# EUROPÄISCHE PATENTSCHRIFT

(11) **EP 3 656 191 B1**
(45) Veröffentlichungstag und Bekanntmachung des Hinweises auf die Patenterteilung: **02.03.2022**
(21) Anmeldenummer: 18739744.3
(22) Anmeldetag: 25.06.2018
(51) Int. Cl.: H05K 5/04, H05K 7/14, H05K 5/02, H05K 7/18

(54) **E-SCHRANK FÜR EIN FAHRZEUG SOWIE MONTAGEVERFAHREN FÜR EINEN E-SCHRANK**
ELECTRONICS CABINET FOR A VEHICLE AND ASSEMBLY METHOD FOR AN ELECTRONICS CABINET
ARMOIRE ÉLECTRONIQUE POUR UN VÉHICULE AINSI QUE PROCÉDÉ DE MONTAGE D'UNE ARMOIRE ÉLECTRONIQUE

(30) Priorität: 31.08.2017 DE 102017215235
(43) Veröffentlichungstag der Anmeldung: 27.05.2020
(73) Patentinhaber: Siemens Mobility GmbH, 81739 München (DE)
(72) Erfinder: TOKMAN, Iossif, 90449 Nürnberg (DE)
(86) Internationale Anmeldenummer: PCT/EP2018/066895
(87) Internationale Veröffentlichungsnummer: WO 2019/042620

(56) Entgegenhaltungen:
- DE-A1- 19 603 368
- DE-A1- 19 832 740

## Beschreibung

Die Erfindung betrifft einen E-Schrank, z.B. einen Fahrzeug-E-Schrank, insbesondere einen Schienenfahrzeug-E-Schrank, zum Einbau von E-Komponenten des Fahrzeugs, insbesondere des Schienenfahrzeugs. Ferner betrifft die Erfindung ein Verfahren zur Montage eines E-Schranks, z. B. eines Fahrzeug-E-Schranks, insbesondere eines Schienenfahrzeug-E-Schranks, für einen Einbau von E-Komponenten des Fahrzeugs, insbesondere des Schienenfahrzeugs. Des Weiteren betrifft die Erfindung ein Fahrzeug, insbesondere ein Schienenfahrzeug.

In vielen technischen Bereichen, z.B. dem Schienenfahrzeugbau (Lokomotiven, Waggons), sind elektrische und/oder elektronische Komponenten z.B. einer Steuerungstechnik und/oder einer Leittechnik, 19-Zoll E-Komponenten und ggf. weitere mechanische, elektrische und/oder elektronische Vorrichtungen, Einrichtungen, Komponenten, Geräte, Systeme etc. in ein oder eine Mehrzahl von Tragsystemen zu integrieren. Diese E-Komponenten sind vorzugsweise in E-Schränken (E für steht hier bevorzugt für elektrisch und/oder elektronisch) zur besseren Zugänglichkeit bei einer Inbetriebsetzung und einer Wartung z.B. des Schienenfahrzeugs eingebaut. E-Schränke sind aus der Patentliteratur DE 196 03 368 A1 und DE 198 32 740 A1 vorbekannt.

Ein Gehäuse eines E-Schranks dient dabei einer Erfüllung von Brandschutzanforderungen, IP-Schutzanforderungen, einer sicheren Befestigung der E-Komponenten (auch: mechanische etc. Komponenten), einer Verdrahtung und/oder einer Klimatisierung der E-Komponenten etc. Um alle Anforderungen sicher erfüllen zu können, hat ein E-Schrank, z.B. für ein Schienenfahrzeug, eine entsprechend robuste Ausgestaltung. Hierbei gibt es immer wieder folgende Probleme: zu hohe Gerüstgewichte der E-Schränke, zu hohe Kosten für eine Herstellung und/oder eine Montage der E-Schränke, zusätzliche Maßnahmen für einen Brandschutz und/oder für eine Kühlung der E-Komponenten, ein größerer Aufwand für eine Nachrüstung/Anbau von E-Komponenten etc.

Im Allgemeinen ist ein Gehäuse eines E-Schranks aus einem Stahlblech gefertigt und umfasst ein tragendes Gerüst, eine Schutzverkleidung (Wandungen: links, rechts, oben, unten, hinten), wenigstens eine Türwandung und/oder Revisionsklappe sowie wenigstens eine Kabeleinführung. Eine mechanisch tragende Konstruktion besteht z. B. aus einem Tragrahmen mit mehreren, oft zwölf, Einzelprofilen plus Eckverbinder (acht). Durch die Fertigung vieler unterschiedlicher Einzelteile entstehen vergleichsweise hohe Material- und Herstellungskosten. Das Gerüst ist in Regel genietet oder geschweißt. Bei einem geschweißten Gerüst muss mit einer Verformung der Schankflächen gerechnet werden (Schweißverzug), bei einer genieteten Ausführung sind Niete sichtbar. Zudem sind aufwändige Maßnahmen für Oberflächen im dekorativen Bereich erforderlich (Verkleidungsteile, Lack etc.).

Ein grundlegendes Problem bei einer Stahlblechkonstruktion ist das Gewicht der mechanischen Teile. Bei E-Schränken werden ferner die E-Komponenten in ein fertiges Gehäuse bzw. den E-Schrank verbaut, bestenfalls kommen vorkonfektionierte Montagetafeln zum Einsatz. In einem zeitlichen Anschluss erfolgt eine Schrankverdrahtung, was zu den hohen Montagekosten führt. Eine Kühlung der eingebauten E-Komponenten erfolgt abhängig von einer Verlustleistung der verbauten E-Geräte über eine Oberfläche des Schanks oder oft auch durch ein Ansaugen von Umgebungsluft. Dazu werden zusätzliche Lüfter und ggf. Filter benötigt. Dies verursacht zusätzliche Kosten für Brandschutzmaßnahmen, Hardware, Steuerung, Überwachung und Montage.

Es ist eine Aufgabe der Erfindung, einen verbesserten E-Schrank, insbesondere für ein Fahrzeug, wie z.B. ein Schienenfahrzeug, anzugeben. Hierbei soll der E-Schrank bevorzugt von seinem Gewicht her leichter als vergleichbare E-Schränke in einem vergleichbaren Anwendungsgebiet und bevorzugt kostengünstiger sein. Ferner soll der E-Schrank vergleichsweise einfach und schnell und somit kostengünstig montieren zu sein. Darüber hinaus ist es eine Aufgabe der Erfindung, ein entsprechendes Fahrzeug, insbesondere ein entsprechendes Schienenfahrzeug, anzugeben.

Die Aufgabe der Erfindung ist mittels eines E-Schranks nach Anspruch 1 und mittels eines Verfahrens nach Anpruch 7 gelöst. Vorteilhafte Weiterbildungen, zusätzliche Merkmale und/oder Vorteile der Erfindung ergeben sich aus den abhängigen Patentansprüchen und/oder der folgenden Beschreibung der Erfindung.

Der erfindungsgemäße E-Schrank umfasst wenigstens zwei, drei, vier, fünf oder sechs Schrankwandungen, wobei wenigstens ein Teil der Schrankwandungen als Tragteile ausgebildet sind, wobei wenigstens ein Tragteil durch wenigstens ein oder genau ein bevorzugtes Strangpressprofil im Wesentlichen konstituiert ist. D.h. der E-Schrank ist auch als ein teilweise offener E-Käfig o.ä. ausbildbar. Hierbei übernimmt ein Tragteil, wie es sein Name ausdrückt, eine für die betreffende Seite des E-Schranks wesentliche, mechanisch tragende Funktion und hat nicht nur eine von einer Umgebung isolierende und dekorative Funktion.

Ein jeweiliges Tragteil kann ein einziges, genau zwei oder eine Mehrzahl von bevorzugten Strangpressprofilen umfassen. Statt einem oder einer Mehrzahl von Strangpressprofilen sind in sämtlichen Ausführungsformen der Erfindung auch nicht stranggepresste Profile, Wandungsprofile, Wandungsteile etc., z.B. aus einem Leichtmetall, wie z.B. Aluminium anwendbar.

Eine E-Komponente ist dabei bevorzugt eine elektrische und/oder elektronische Komponente. Es ist natürlich möglich, zusätzlich oder alternativ, darunter eine optische, eine mechanische und/oder eine pneumatische Komponente etc. zu subsumieren.

In einer Ausführungsform kann eine Schrankwandung als eine Türwandung und/oder eine Schrankwandung als eine Rückwandung des E-Schranks ausgebildet sein, wobei die Schrankwandung und/oder die Rückwandung durch wenigstens ein oder genau ein bevorzugtes Strangpressprofil im Wesentlichen konstituiert ist. In einer Ausführungsform können eine, zwei, drei, vier oder mehr Schrankwandungen als eine Schrankzarge, ein Schrankrahmen oder ein Schrankgehäuse ausgebildet sein, wobei die Schrankzarge, der Schrankrahmen oder das Schrankgehäuse durch wenigstens ein oder genau ein einziges bevorzugtes Strangpressprofil im Wesentlichen konstituiert ist.

In einer Ausführungsform kann die/eine Schrankzarge wenigstens ein (einziges und/oder zusammengesetztes) Tragteil aufweisen, welche (Schrankzarge) durch genau ein, genau zwei oder wenigstens ein bevorzugtes Strangpressprofil konstituiert ist. Ferner kann der/ein Schrankrahmen maximal oder genau drei (einzige und/oder zusammengesetzte) Tragteile aufweisen, welcher (Schrankrahmen) durch genau ein, genau zwei oder wenigstens ein bevorzugtes Strangpressprofil konstituiert ist. Des Weiteren kann das/ein Schrankgehäuse maximal, genau oder wenigstens vier (einzige und/oder zusammengesetzte) Tragteile aufweisen, welches (Schrankgehäuse) durch genau ein, genau zwei oder wenigstens ein bevorzugtes Strangpressprofil konstituiert ist.

In einer Ausführungsform kann die/eine Schrankwandung genau ein Tragteil umfassen, welches (Schrankwandung) durch genau ein, genau zwei oder wenigstens ein bevorzugtes Strangpressprofil konstituiert ist. Ferner kann die/eine Rückwandung genau ein Tragteil umfassten, welche (Rückwandung) durch genau ein, genau zwei oder wenigstens ein bevorzugtes Strangpressprofil konstituiert ist. D.h. statt jeweils einem bevorzugten Strangpressprofil je Wandung können auch eine Mehrzahl von bevorzugten Strangpressprofilen, insbesondere zwei bevorzugte Strangpressprofile (jeweils als Tragteil bezeichnet), angewendet werden. Hierbei sind einander betreffende Strangpressprofile an ihren Längsseiten fest und bevorzugt wieder lösbar miteinander verbunden.

In einer Ausführungsform kann die Schrankzarge, der Schrankrahmen oder das Schrankgehäuse, wenigstens zeitlich vor einer Montage des E-Schranks, stofflich einstückig oder integral ausgebildet sein. Ferner kann das Tragteil stofflich einstückig oder integral ausgebildet sein. Des Weiteren können Tragteile, wenigstens zeitlich vor einer Montage des E-Schranks, miteinander stofflich einstückig verbunden oder integral ausgebildet sein. Darüber hinaus kann die Schrankwandung stofflich einstückig oder integral ausgebildet sein. Weiterhin können Schrankwandungen, wenigstens zeitlich vor einer Montage des E-Schranks, miteinander stofflich einstückig verbunden oder integral ausgebildet sein.

In einer Ausführungsform können sämtliche Schrankwandungen oder Tragteile des E-Schranks, aus genau zwei, genau drei, genau vier, genau fünf oder genau sechs unterschiedlichen ursprünglichen Strangpressprofilen hergestellt sein. Ferner können sämtliche Schrankwandungen oder Tragteile der Schrankzarge, des Schrankrahmens oder des Schrankgehäuses aus genau einem oder genau zwei unterschiedlichen, ursprünglichen Strangpressprofilen hergestellt sein. Darüber hinaus kann die Türwandung und/oder die Schrankwandung jeweils aus einem einzigen ursprünglichen Strangpressprofil oder aus unterschiedlichen ursprünglichen Strangpressprofilen hergestellt sein.

In einer Ausführungsform kann das betreffende Strangpressprofil aus einem Leichtmetall, z.B. Aluminium, hergestellt sein. Ferner kann das betreffende Strangpressprofil im Wesentlichen als ein Vollprofil ausgebildet sein. Des Weiteren kann die betreffende Schrankwandung innen und/oder außen strukturiert sein. Darüber hinaus kann die betreffende Schrankwandung innen wenigstens eine Längsnut zur Befestigung der betreffenden E-Komponente aufweisen. Weiterhin kann der E-Schrank wenigstens eine E-Komponente aufweisen. Der erfindungsgemäße E-Schrank kann durch ein erfindungsgemäßes Montageverfahren hergestellt sein.

Bei dem erfindungsgemäßen Verfahren zur Montage des E-Schranks wird auf Anspruch 7 verwiesen Vorbereitend für das Montageverfahren (d.h. zeitlich vor der Vormontage) kann ein Ausschnitt und/oder eine Bohrung in ein Strangpressprofil für die Schrankzarge, den Schrankrahmen oder das Schrankgehäuse und/oder die Schrankwandung eingebracht werden. Ferner kann ein Ausschnitt und/oder ein abgeschrägter Ausschnitt entsprechend einer Höhe und einer Breite des E-Schranks in das Strangpressprofil für die Schrankzarge, den Schrankrahmen bzw. das Schrankgehäuse eingebracht werden. Solch ein bevorzugt V-förmiger Ausschnitt und/oder solch ein abgeschrägter Ausschnitt wird bevorzugt gefräst.

Ferner kann vorbereitend für das Montageverfahren die Rückwandung in einem Bereich bei einer Längsnut und/oder in einem Bereich einer Kühleinrichtung bearbeitet werden. Des Weiteren kann die Türwandung in einem Bereich bei einer Profilaufnahme, einem Profilschenkel und/oder einer Biegung einer Lasche bearbeitet werden. Die mechanische Nachbearbeitung der Rückwandung bzw. des Strangpressprofils der Rückwandung und/oder der Türwandung bzw. des Strangpressprofils der Türwandung erfolgt bevorzugt durch Fräsen.

Im Rahmen der Vormontage kann die E-Komponente in/an einer Längsnut des Strangpressprofils für die Schrankzarge, den Schrankrahmen oder das Schrankgehäuse und/oder die Rückwandung montiert werden. Ferner kann die E-Komponente entlang der Längsnut im Wesentlichen kontinuierlich (stufenlos) verschieblich vorgesehen sein. Darüber hinaus kann eine Kabeldurchführung und/oder eine andere Komponente am Strangpressprofil für die Schrankzarge, den Schrankrahmen oder das Schrankgehäuse und/oder die Rückwandung montiert werden.

Im Rahmen der Endmontage kann das Strangpressprofil für die Schrankzarge, den Schrankrahmen oder das Schrankgehäuse zunächst zu einem Winkel gebogen werden. D.h. das Strangpressprofil weist dabei bevorzugt einen ca. 90°-Winkel auf. In einem zeitlichen Anschluss daran kann die Rückwandung am/im Winkel des Strangpressprofils für die Schrankzarge, den Schrankrahmen oder das Schrankgehäuse montiert werden. In einem zeitlichen Anschluss daran wiederum kann das Strangpressprofil für die Schrankzarge, den Schrankrahmen oder das Schrankgehäuse zu einem U-förmigen Strangpressprofil an der Rückwandung gebogen werden. Hierbei weist das Strangpressprofil bevorzugt zwei ca. 90°-Winkel auf.

In einem zeitlichen Anschluss daran kann das Strangpressprofil für die Schrankzarge, den Schrankrahmen oder das Schrankgehäuse zu einem in einer Umfangsrichtung an der Rückwandung vollständig geschlossenen Strangpressprofil gebogen werden. In einem zeitlichen Anschluss kann die Türwandung an der Schrankzarge, dem Schrankrahmen oder dem Schrankgehäuse montiert werden. Der E-Schrank kann als ein erfindungsgemäßer E-Schrank ausgebildet sein. Das erfindungsgemäße Fahrzeug weist einen erfindungsgemäßen E-Schrank und/oder einen erfindungsgemäß hergestellten E-Schrank auf.

Das erfindungsgemäße Fahrzeug, insbesondere das erfindungsgemäße Schienenfahrzeug, weist einen erfindungsgemäßen E-Schrank auf. Die Erfindung ist z.B. auf ein Schienenfahrzeug (z.B.: Eisenbahnfahrzeug, Triebfahrzeug, Lokomotive, Triebkopf, Triebwagen, selbstfahrendes Spezialfahrzeug für bahnbetriebliche Aufgaben, Eisenbahnwagen bzw. Waggon (Schienenfahrzeug ohne eigenen Antrieb) etc.) oder ein Kraftfahrzeug (z.B. Personentransportwagen, Bus, ATV (All Terrain Vehicle, Gelände-/Militärfahrzeug), Nutzfahrzeug, (Schwerst-) Lastkraftwagen, Baufahrzeug, Sonderfahrzeug, Baumaschine etc.), also Fahrzeuge im Allgemeinen (inkl. eines Waggons, also ein allgemeines Fahrzeug ohne eigenen Antrieb) anwendbar. Ferner ist die Erfindung auf ein Boot, ein Schiff, ein Flugzeug (Fortbewegungsmittel) oder einen stationären E-Schrank anwendbar.

Gemäß der Erfindung ergeben sich signifikante Kosteneinsparungen, signifikante Gewichtseinsparungen sowie eine Reduzierung eines Montageaufwands. Im Einzelnen ergeben sich eine starke Reduzierung einer Anzahl mechanischer Teile gegenüber dem Stand der Technik. Eine Gewichtseinsparung eines mechanischen Anteils des E-Schranks beläuft sich dabei auf bis zu 45%. Eine Kosteneinsparung bei einem Material des mechanischen Anteils des E-Schranks beläuft sich auf bis zu 40%. Durch eine Verwendung von Strangpressprofilen aus Aluminium und eine Möglichkeit eine geriffelte oder gerippte Oberfläche zu formen, kann deutlich mehr Wärme aus dem Schrank abgeführt werden, was die Lebensdauer der E-Komponenten durch ein vergleichsweise geringes Temperaturniveau erhöht. Ferner reduziert sich ein Energiebedarf für eine aktive Schrankkühlung und ermöglicht einen vollständig geschlossenen E-Schrank.

Gemäß der Erfindung sind die Strangpressprofile und Bauteile standardisiert. Ein großer Montageanteil und eine Verdrahtung erfolgen bei einer Vormontage des E-Schranks (z.B. in einer Montagevorrichtung). Dies ermöglicht eine bessere Zugänglichkeit zu den E-Komponenten und verringert eine Montagezeit und Kosten. Eine Nachrüstung des E-Schranks mit E-Komponenten ist mit geringem Aufwand möglich, weil die vorhandenen Nuten der multifunktionellen Tragteile bzw. Strangpressprofile ein flexibles Befestigungssystem realisieren. Elektrische und/oder elektronische Einbauten können bei Bedarf auch noch im eingebauten Zustand im Fahrzeug einfach verschoben werden. Die sichtbaren Oberflächen des E-Schranks haben keine Nietköpfe und/oder Verformungen. Ferner ergeben sich eine Reduzierung der Kosten für eine Lackierung und ein verbessertes Design.

Die Erfindung ist im Folgenden anhand von Ausführungsbeispielen unter Bezugnahme auf die beigefügte schematische und nicht maßstabsgetreue Zeichnung näher erläutert. Abschnitte, Elemente, Bauteile, Einheiten, Schemata und/oder Komponenten, welche eine identische, univoke oder analoge Ausbildung und/ oder Funktion besitzen, sind in der Figurenbeschreibung (s.u.), der Bezugszeichenliste, den Patentansprüchen und in den Figuren (FIG) der Zeichnung mit denselben Bezugszeichen gekennzeichnet. Eine mögliche, in der Erfindungsbeschreibung (s.o.) nicht erläuterte, in der Zeichnung nicht dargestellte und/oder nicht abschließende Alternative, eine statische und/oder kinematische Umkehrung, eine Kombination etc. zu den Ausführungsbeispielen der Erfindung bzw. einer Komponente, einem Schema, einer Einheit, einem Bauteil, einem Element oder einem Abschnitt davon, kann ferner der Bezugszeichenliste und/oder der Figurenbeschreibung entnommen werden.

Bei der Erfindung kann ein Merkmal (Abschnitt, Element, Bauteil, Einheit, Komponente, Funktion, Größe etc.) positiv, d.h. vorhanden, oder negativ, d.h. abwesend, ausgestaltet sein, wobei ein negatives Merkmal als Merkmal nicht explizit erläutert ist, wenn nicht gemäß der Erfindung Wert darauf gelegt ist, dass es abwesend ist. Ein Merkmal dieser Spezifikation (Beschreibung, Bezugszeichenliste, Patentansprüche, Zeichnung) kann nicht nur in einer angegebenen Art und/oder Weise, sondern auch in einer anderen Art und/oder Weise angewendet sein (Isolierung, Zusammenfassung, Ersetzung, Hinzufügung, Alleinstellung, Weglassung etc.). Insbesondere ist es möglich, anhand eines Bezugszeichens und einem diesen zugeordneten Merkmal, bzw. vice versa, in der Beschreibung, der Bezugszeichenliste, den Patentansprüchen und/oder der Zeichnung, ein Merkmal in den Patentansprüchen und/oder der Beschreibung zu ersetzen, hinzuzufügen oder wegzulassen. Darüber hinaus kann dadurch ein Merkmal in einem Patentanspruch ausgelegt und/oder näher spezifiziert werden.

Die Merkmale dieser Spezifikation sind (angesichts des (meist unbekannten) Stands der Technik) auch als optionale Merkmale interpretierbar; d.h. jedes Merkmal kann als ein fakultatives, arbiträres oder bevorzugtes, also als ein nicht verbindliches, Merkmal aufgefasst werden. So ist eine Herauslösung eines Merkmals, ggf. inkl. seiner Peripherie, aus einem Ausführungsbeispiel möglich, wobei dieses Merkmal dann auf einen verallgemeinerten Erfindungsgedanken übertragbar ist. Das Fehlen eines Merkmals (negatives Merkmal) in einem Ausführungsbeispiel zeigt, dass das Merkmal in Bezug auf die Erfindung optional ist. Ferner ist bei einem Artbegriff für ein Merkmal auch ein Gattungsbegriff für das Merkmal mitlesbar (ggf. weitere hierarchische Gliederung in Untergattung, Sektion etc.), wodurch, z.B. unter Beachtung von Gleichwirkung und/oder Gleichwertigkeit, eine Verallgemeinerung eines oder dieses Merkmals möglich ist.

In der lediglich beispielhaften Zeichnung zeigen die Fig. 1 bis 12 einen grundlegenden Aufbau einer ersten Ausführungsform eines erfindungsgemäßen E-Schranks für ein Fahrzeug, insbesondere ein Schienenfahrzeug. Die Fig. 13 bis 17 zeigen eine mechanische Nachbearbeitung von Schrankwandungen für eine Montage der ersten Ausführungsform des E-Schranks. Die Fig. 18 und 19 zeigen eine Vormontage von E-Komponenten an Schrankwandungen des E-Schranks. Die Fig. 20 bis 23 und 25 zeigen eine Montage der Schrankwandungen der ersten Ausführungsform des E-Schranks zum E-Schrank. Die Fig. 24 und 25 zeigen eine zweite Ausführungsform des E-Schranks als E-Schrank für 19-Zoll-Komponenten. Und die Fig. 26 zeigt eine dritte Ausführungsform des E-Schranks.

Die Erfindung ist im Folgenden anhand von Ausführungsbeispielen dreier Ausführungsformen einer Variante eines erfindungsgemäßen E-Schranks 0 für ein Fahrzeug (Fahrzeug-E-Schrank 0), insbesondere ein Schienenfahrzeug näher erläutert (Schienenfahrzeug-E-Schrank 0). Die Erfindung ist jedoch nicht auf eine solche Variante, solche Ausführungsformen und/oder die nachfolgend erläuterten Ausführungsbeispiele beschränkt, sondern ist von grundlegenderer Natur, sodass die Erfindung auf sämtliche Fahrzeuge (s.o.) oder auch auf stationäre E-Schränke angewendet werden kann. In der Zeichnung sind nur diejenigen Abschnitte eines Gegenstands der Erfindung dargestellt, welche für ein Verständnis der Erfindung notwendig sind.

Ferner bezieht sich die Erläuterung der Erfindung anhand der Zeichnung im Folgenden auf eine Breitenrichtung B bzw. eine Breitenachse B (Breite B), eine Hochrichtung H bzw. eine Hochachse H (Höhe H) sowie eine Tiefenrichtung T bzw. eine Tiefenachse T (Tiefe T) des E-Schranks 0. Obwohl die Erfindung detaillierter durch bevorzugte Ausführungsbeispiele näher beschrieben und illustriert ist, so ist die Erfindung nicht durch die offenbarten Ausführungsbeispiele eingeschränkt. Andere Variationen können hieraus und/oder aus Obigem (Erfindungsbeschreibung) abgeleitet werden, ohne den Schutzumfang der Erfindung zu verlassen.

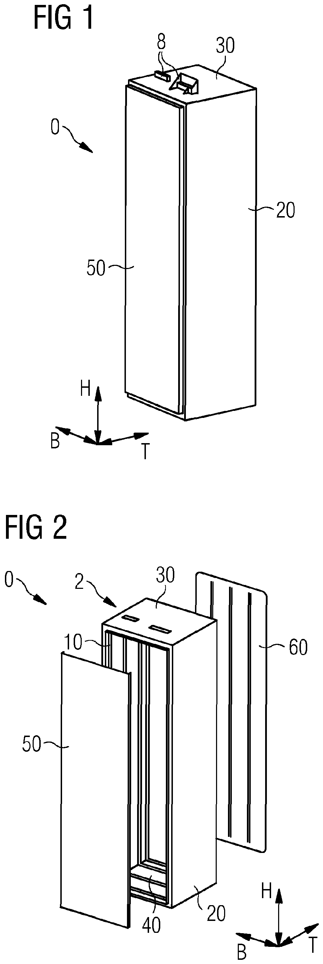

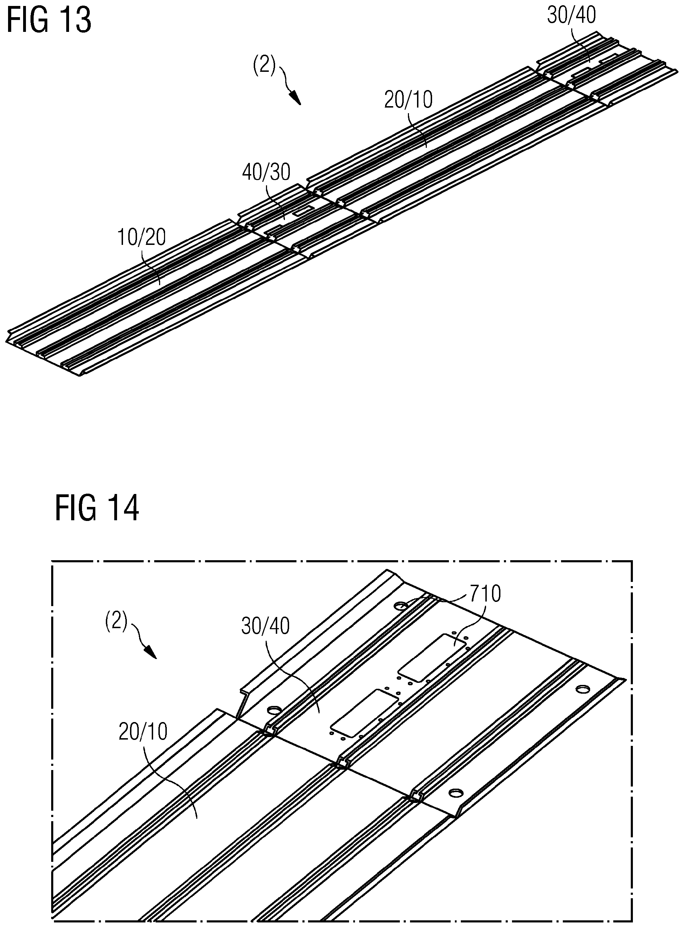

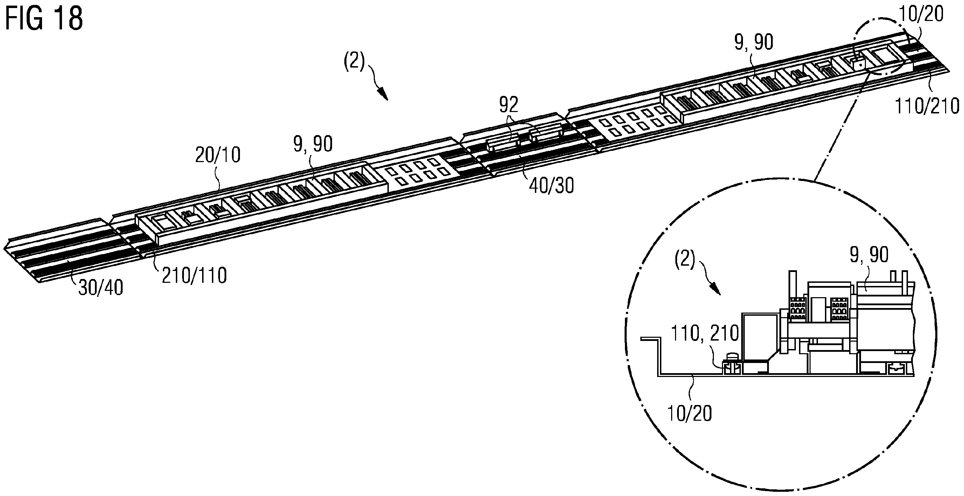

Die Fig. 1 und 2 zeigen einen Aufbau eines erfindungsgemäßen E-Schranks 0 mit einer Schrankzarge 2, einem Schrankrahmen 2 oder einem Schrankgehäuse 2. Eine Schrankzarge 2 umfasst dabei wenigstens eine Schrankwandung 10, 20, 30, 40 bzw. wenigstens ein Tragteil 10, 20, 30, 40, aufweisend wenigstens ein bevorzugtes Strangpressprofil (s. u.). Ein Schrankrahmen 2 umfasst dabei maximal drei Schrankwandungen 10, 20, 30, 40 bzw. maximal drei Tragteile 10, 20, 30, 40, jeweils aufweisend wenigstens ein bevorzugtes Strangpressprofil. Ein Schrankgehäuse 2 umfasst dabei maximal, genau oder wenigstens vier Schrankwandungen 10, 20, 30, 40 bzw. maximal, genau oder wenigstens vier Tragteile 10, 20, 30, 40, jeweils aufweisend wenigstens ein bevorzugtes Strangpressprofil (vgl. auch die Fig. 13 und 18).

Ferner zeigen die Fig. 1 und 2 eine Türwandung 50 bzw. eine Deckelwandung 50 und eine Rückwandung 60 jeweils als ein Tragteil 50, 60, jeweils aufweisend wenigstens ein bevorzugtes Strangpressprofil. Das betreffende Strangpressprofil besteht bevorzugt aus einem Leichtmetall, wie z.B. Aluminium, und vereint mehrere Funktionen in sich (Verkleidung, Tragsystem(e), Versteifung etc.) und ersetzt mehrere Bauteile eines herkömmlichen E-Schranks. Statt einem oder einer Mehrzahl von Strangpressprofilen sind bei sämtlichen Ausführungsformen der Erfindung auch nicht stranggepresste Profile, Wandungen, Wandungsteile etc. anwendbar.

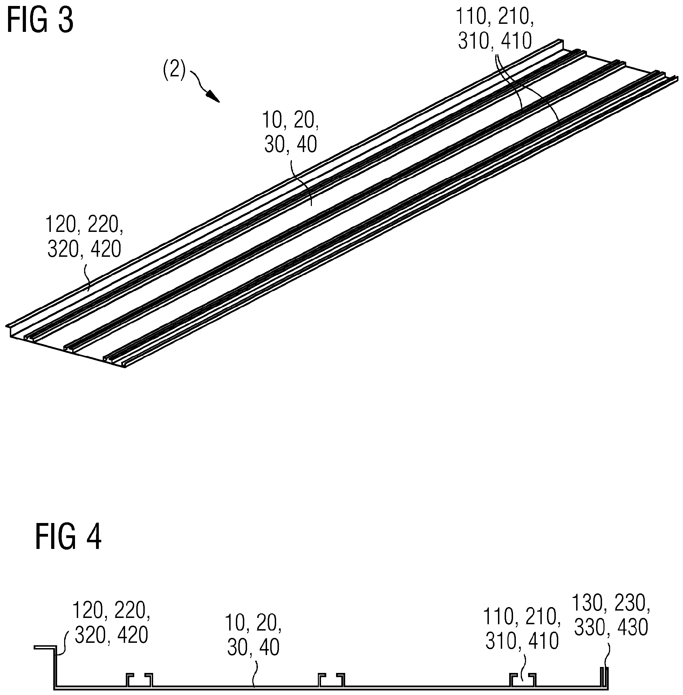

Die Fig. 3 und 4 (für E-Schränke 0 mit einer Tiefe T bis ca. 600mm) zeigen eine beispielhafte Ausbildung eines ursprünglichen Strangpressprofils z.B. für die Schrankwandungen 10, 20, 30, 40, also die Schrankzarge 2, den Schrankrahmen 2 oder das Schrankgehäuse 2. Eine Profilgeometrie (Querschnitt, Fig. 4) ist durch Festigkeitsanforderungen, Befestigungsmöglichkeiten der E-Komponenten 9, thermische Anforderungen, Brandschutzanforderungen etc. bestimmt. Das Strangpressprofil besitzt Längsnuten 110, 210, 310, 410 zur Befestigung einer E-Komponente 9 und/oder einer anderweitigen Komponente sowie z.B. zur Befestigung einer Montageplatte mit Hilfe eines Verbindungsteils und/oder eines Befestigungsteils, wie z.B. einer Nutenschraube und/oder einem Nutenstein.

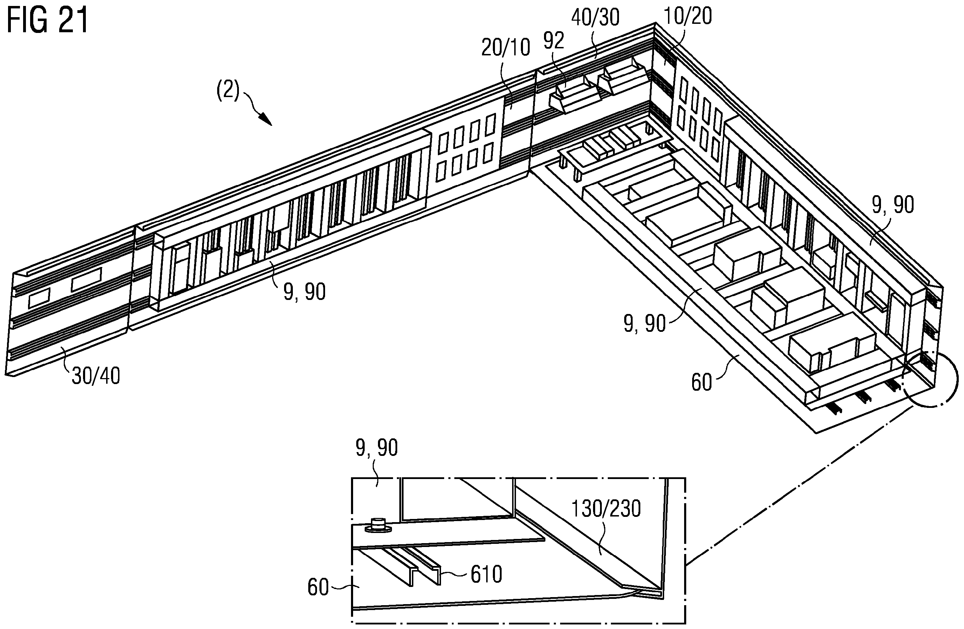

Ein bevorzugter bevorzugt L-förmiger Profilschenkel 120, 220, 320, 420 am Strangpressprofil ist für eine Befestigung und/oder Abdichtung der Türwandung 50 vorgesehen. In eine bevorzugte Profilaufnahme 130, 230, 330, 430 wird bei einer Montage (Endmontage) des E-Schranks 0 die Rückwandung 60 eingeschoben und bevorzugt geklemmt. Die Profilaufnahme 130, 230, 330, 430 hat bevorzugt einen insbesondere engen U-förmigen Querschnitt (vgl. Fig. 21 unten Mitte). Eine Profillänge des Strangpressprofils ist von einer Höhe H und/oder einer Breite B des E-Schranks 0 abhängig. Vorliegend entspricht ferner die Breite B einer Tiefe T des E-Schranks 0 (im Wesentlichen quadratische Deckenwandung 30 und Bodenwandung 40). Andere Abmessungen sind natürlich anwendbar.

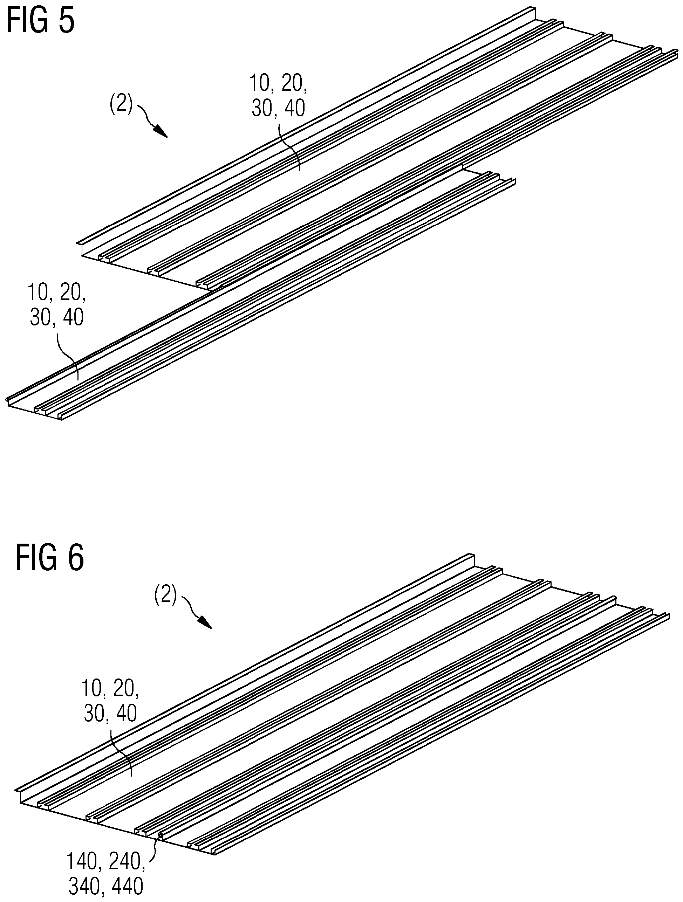

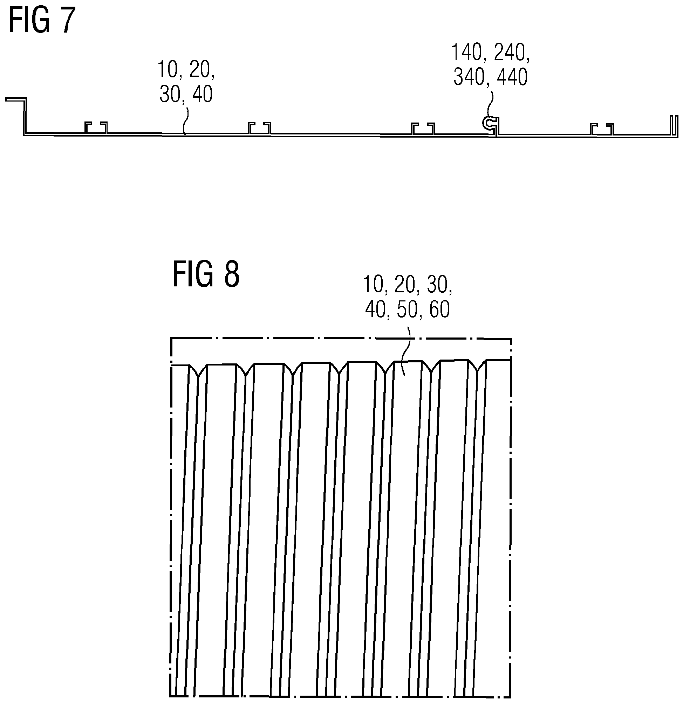

Vergleichsweise tiefe T E-Schränke 0 (vgl. die Fig. 5 bis 7, für E-Schränke 0 mit einer Tiefe von mehr als ca. 600mm) weisen ggf. für bestimmte Seitenwandungen 10, 20, 30, 40, 50, 60 mehrere zusammengesetzte Tragteile 10, 20, 30, 40, (50), (60) und/oder ggf. einteilige Tragteile (10), (20), (30), (40), 50, 60 auf. Hierbei sind einander betreffende Tragteile (zusammengesetztes Tragteil 10, 20, 30, 40, (50), (60)) bevorzugt mittels einer Nut-Feder-Verbindung 140, 240, 340, 440 (Fig. 7) aneinander bevorzugt lösbar vorgesehen bzw. befestigt.

Je nach Designanforderungen können die Strangpressprofile 10, 20, 30, 40, 50, 60 glatte oder strukturierte Oberflächen (vgl. die Fig. 8) besitzen. Eine solche Struktur ist z.B. geriffelt, weist Rippen und/oder Nuten etc. auf. Bei einer innen und/oder außen strukturierten Oberfläche kann deutlich mehr Wärme über eine Oberfläche des E-Schranks 0 abgeführt werden. All dies, also das zu den Fig. 3 bis 7 Gesagte, kann natürlich auch auf wenigstens eine Schrankwandung 50, 60 angewendet werden.

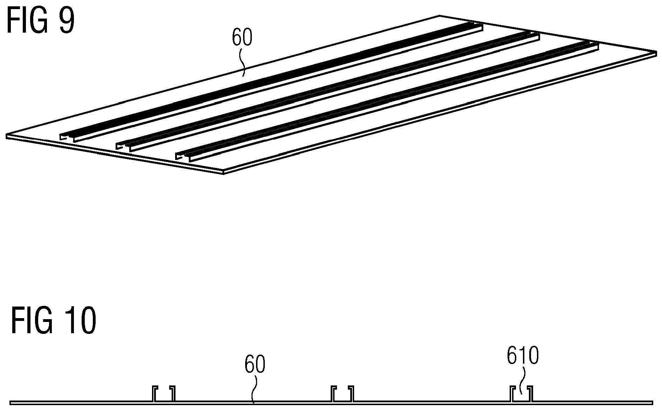

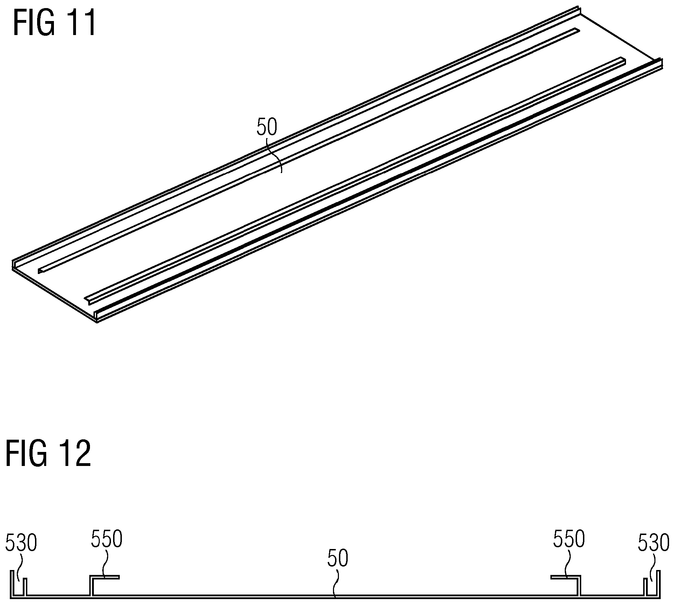

Die Fig. 9 und 10 zeigen eine beispielhafte Ausführung der Rückwandung 60 mit bevorzugt wenigstens einer Längsnut 610 zur Befestigung einer E-Komponente 9 und/oder einer anderen Komponente. Die Fig. 11 und 12 zeigen eine beispielhafte Ausführung der Türwandung 50 (bevorzugt keine Längsnut). Wenigstens eine Profilaufnahme 530 an der Türwandung 50 ist für den Anbau einer Türdichtung und/oder eines Beschlags vorgesehen. Hierbei kann die Profilaufnahme 530 U-förmig mit bevorzugt einem kürzeren Schenkel (bevorzugt innen) ausgebildet sein. Bevorzugt wenigstens ein Profilschenkel 550 ist für eine Befestigung von Kleinteilen vorgesehen und kann ferner einer Stabilität der Türwandung 50 dienen. All dies, also das zu den Fig. 8 bis 12 Gesagte, kann natürlich auch auf wenigstens eine Schrankwandung 10, 20, 30, 40 angewendet werden.

Je nach einer gewünschten Konstruktion des E-Schranks 0 müssen die Strangpressprofile vor einer gegenseitigen Montage (Zusammenbau) zum E-Schrank 0 mechanisch nachbearbeitet werden (Fig. 13 bis 17). So können in einem ersten Schritt (Fig. 13 bis 15) alle notwendigen Ausschnitte 710 und/oder Bohrungen 710 etc. für eine Schankbefestigung, eine Kabeleinführung (Stecker) und/oder einen Beschlag etc. in ein bevorzugt einziges Strangpressprofil für die Schrankzarge 2, den Schrankrahmen 2 bzw. das Schrankgehäuse 2 eingebracht werden (vgl. insbesondre die Fig. 14). Dies gilt natürlich gleichermaßen für die Strangpressprofile der Schrankwandungen 50, 60.

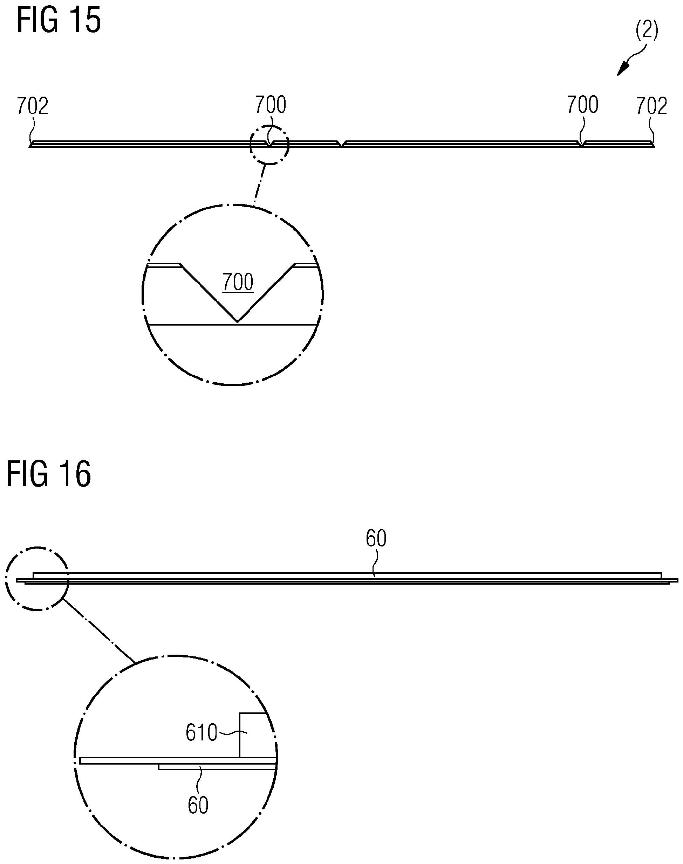

In einem zweiten Schritt können bevorzugt V-förmige Ausschnitte 700 und/oder abgeschrägte Ausschnitte 702 entsprechend einer Höhe H und einer Breite B des E-Schranks 0 in das bevorzugt einzige Strangpressprofil für die Schrankzarge 2, den Schrankrahmen 2 bzw. das Schrankgehäuse 2 eingebracht, insbesondere gefräst, werden (vgl. Fig. 15). Eine Abmessung der Tragteile 10, 20 entspricht der Höhe H der Seitenwandungen 10, 20; und eine Abmessung die Tragteile 30, 40 entspricht der Breite B des E-Schranks 0 (Deckenwandung 30 und Bodenwandung 40).

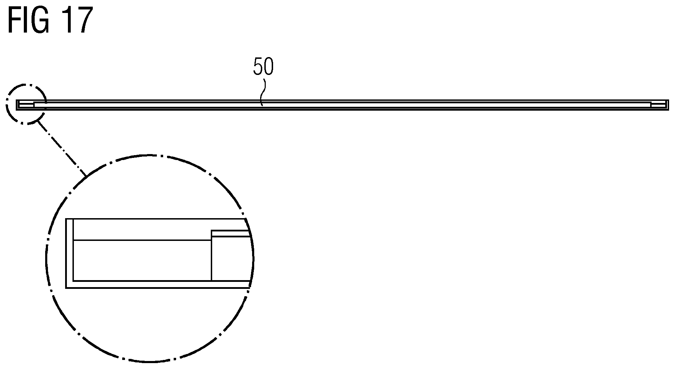

Je nach einer gewünschten Konstruktion des E-Schranks 0 kann bei einer mechanischen Nachbearbeitung der Rückwandung 60 bzw. eines Strangpressprofils der Rückwandung 60 ein Bereich bei den Längsnuten 610 und/oder ein Bereich bei einer Kühleinrichtung gefräst werden (Fig. 16). Ferner kann je nach einer gewünschten Konstruktion des E-Schranks 0 bei einer mechanischen Nachbearbeitung der Türwandung 50 bzw. eines Strangpressprofils der Türwandung 50 ein Bereich bei einer Profilaufnahme 530, einem Profilschenkel 550 und/oder einer Biegung einer Lasche (Fig. 17) gefräst werden.

Je nach einer Konstruktion des E-Schranks 0, einem Bearbeitungsaufwand, einer geplanten Produktionszahl von E-Schränken 0 und somit Kosten, kann wenigstens eine Gehäusekomponente (z.B. die Türwandung 50) auch als ein Blechbiegeteil oder anderweitig ausgebildet werden.

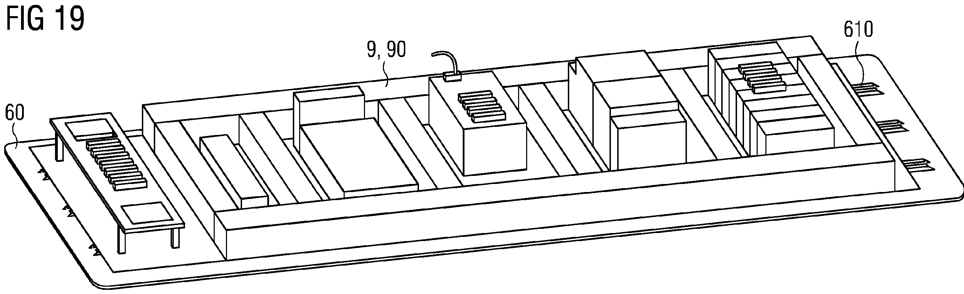

Im Folgenden ist eine Montage bzw. eine Reihenfolge bei der Montage des E-Schranks 0, z.B. mit E-Komponenten 9 (92) einer Steuerungstechnik für Schienenfahrzeuge, näher erläutert (Fig. 18 bis 23 und 25), wobei zunächst eine Vormontage von E-Komponenten 9 an einem einzigen Strangpressprofil bzw. einer anderweitigen Vorrichtung für die Schrankzarge 2, den Schrankrahmen 2 bzw. das Schrankgehäuse 2, bzw. an der Schrankzarge 2, dem Schrankrahmen 2 bzw. dem Schrankgehäuse 2, und/oder der Rückwandung 60 erfolgt (Fig. 18 und 19).

Bei der Vormontage kann z.B. ein Positionieren und/oder ein Befestigen einer vormontierten und/oder vorverdrahteten E-Tafel 90 (E-Komponente 9) mit Komponenten einer Fahrzeugleittechnik erfolgen. In Längsrichtung B, H des Strangpressprofils bzw. der anderweitigen Vorrichtung kann die betreffende E-Tafel 90 stufenlos verschoben und positioniert werden. Die Befestigung, insbesondere an wenigstens einer späteren Schrankwandung 10, 20 bzw. einem Tragteil 10, 20, erfolgt an/in den Längsnuten 110, 210 mittels Nutenschrauben oder mit Nutensteinen und Schrauben (vgl. Detail der Fig. 18 links).

Ferner kann ein Positionieren und Befestigen von Kabeldurchführungen 92 und anderer Komponenten (Stecker) z.B. an wenigstens einer späteren Schrankwandung 30, 40 bzw. einem Tragteil 30, 40 erfolgen. Des Weiteren kann ein Positionieren und/oder ein Befestigen einer vormontierten und/oder vorverdrahteten E-Tafel 90 (E-Komponente 9) mit Komponenten einer Fahrzeugleittechnik, Steckern und andere Komponenten analog auf der Rückwandung 60 erfolgen. Dies kann auch für die Türwandung 50 gelten, was aber vorliegend nicht erfolgt.

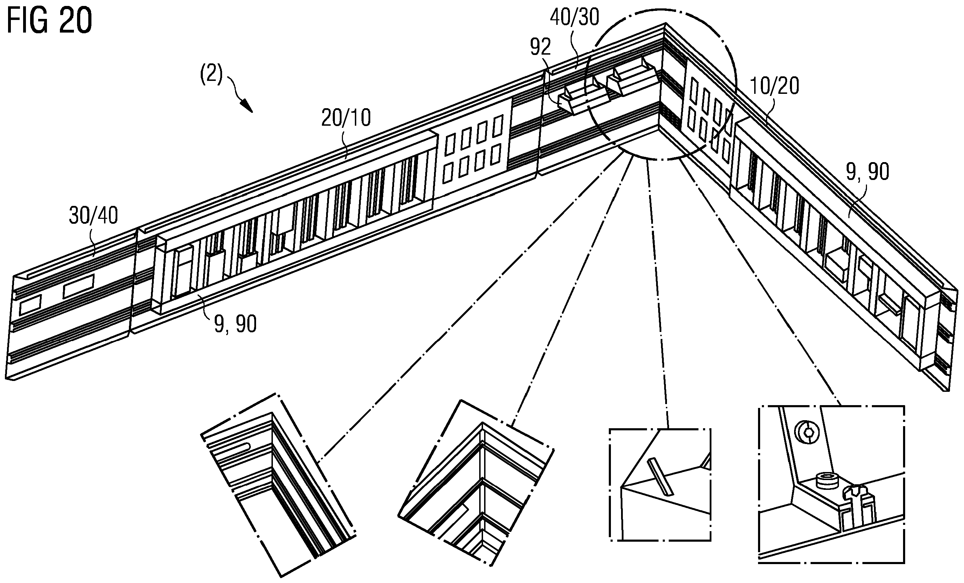

Erst in einer zeitlichen Folge wird der E-Schrank 0 mit Komponenten der Steuerungstechnik (Fig. 20) zusammengebaut. Zeitlich nach der Vormontage der E-Komponenten 9 (Fig. 18 und 19) werden zunächst bevorzugt zwei Tragteile 40/30, 20/10 (eine für eine Seitenwandung 20/10 und eine für die Decken- bzw. Bodenwandung 40/30) aufeinander zugebogen und im Bereich der V-förmigen Ausschnitte 700 mechanisch fest verbunden. Je nach einer Konstruktion des E-Schranks 0, Brandschutzanforderungen, zu erwartenden mechanischen Belastungen, Fertigungsmöglichkeiten etc. erfolgt die mechanische Verbindung der Tragteile 40/30, 20/10 entweder durch Kleben (Fig. 20 unten links), Schweißen (Fig. 20 unten Mitte links), eingesetzten Verbindungselementen (Fig. 20 unten Mitte rechts) oder mit Hilfe geschraubter Verbindungselemente (Fig. 20 unten rechts).

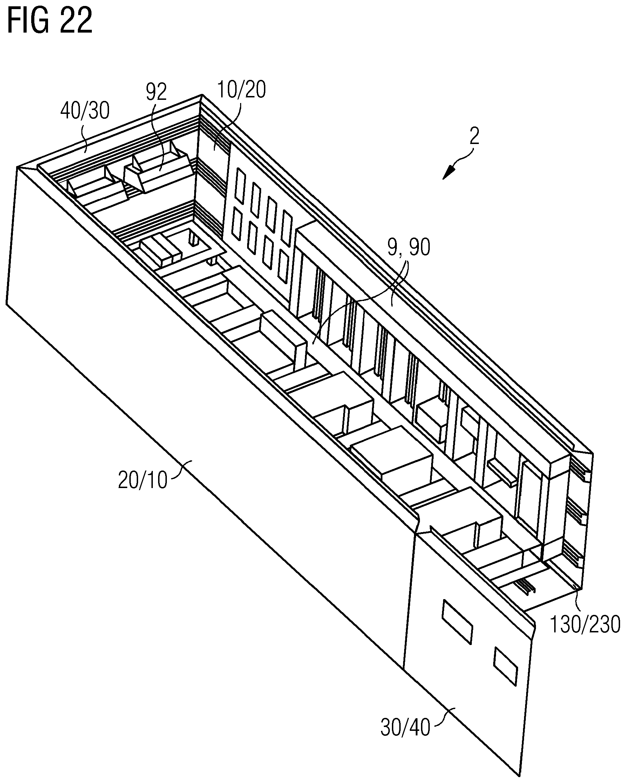

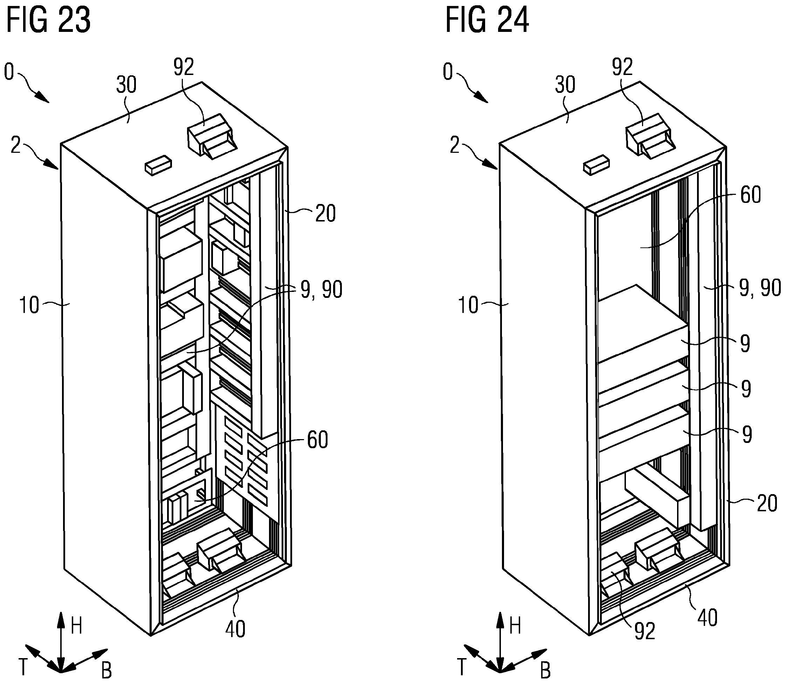

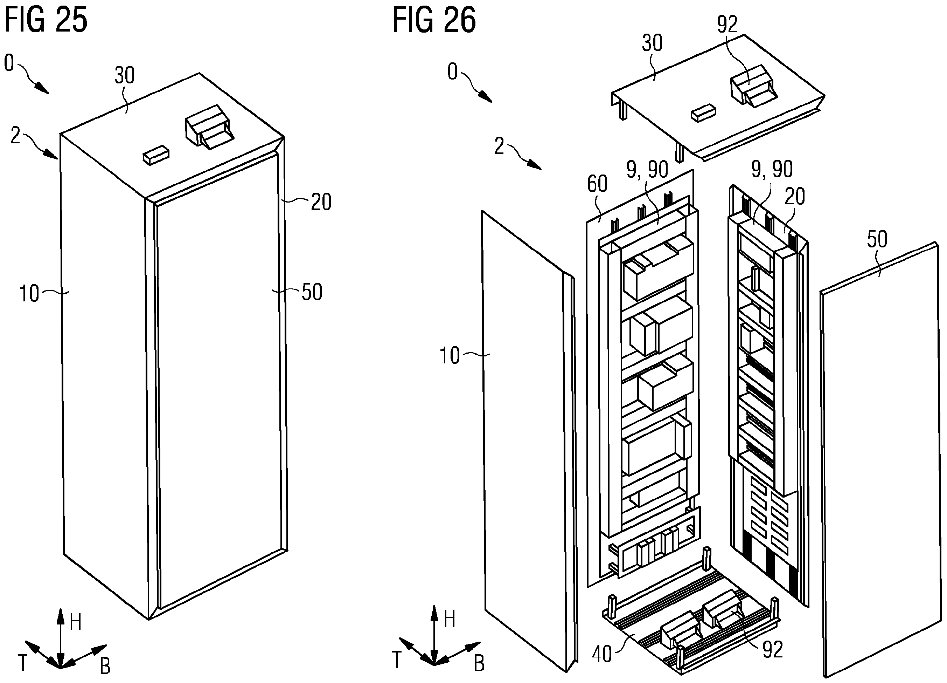

Nachdem bevorzugt lediglich zwei Tragteile 40/30, 20/10 (Seitenwandung 20/10 und Decken- bzw. Bodenwandung 40/30) aufeinander gebogen wurden (bevorzugt 90°-Winkel), wird die vormontierte Rückwandung 60 in das Tragteil 20/10 eingeschoben (Profilaufnahme 130/230) und positioniert (Fig. 21). Bei Bedarf wird abgedichtet. Analoges kann für das Tragteil 40/30 gelten. In einer zeitlichen Folge (Fig. 22) werden das Tragteil 20/10 und dann das Tragteil 30/40 analog gebogen. Beim Biegen wird die Rückwandung 60 (Tragteil 60) mittels der Profilaufnahmen 230/130, 330/430 der Tragteile 20/10, 30/40 geklemmt. Ein Fügen im Bereich der V-förmigen Ausschnitte 700 erfolgt wie oben beschrieben (Fig. 20). Bei Bedarf kann wiederum abgedichtet werden. Danach können zusätzliche elektrische Verbindungen etc. vorgesehen/eingebracht werden. Die Fig. 23 zeigt den fast fertigen E-Schrank 0 (ohne Türwandung 50 bzw. Deckelwandung 50) in einer aufgerichteten Stellung. Die Fig. 25 zeigt den fertigen E-Schrank 0.

Die Fig. 24 zeigt analog zur Fig. 23 einen fast fertigen E-Schrank 0 (zweite Ausführungsform) für 19-Zoll E-Komponenten 9. Eine Vormontage eines solchen E-Schranks 0 erfolgt ähnlich wie es in Fig. 18 dargestellt ist. Hierbei werden, statt E-Komponenten 9, Montageschienen 90 für die Befestigung von 19-Zoll E-Komponenten 9, Kabeldurchführungen 92 und anderen Komponenten etc. positioniert und fixiert. D.h. ein Zusammenbau erfolgt analog zu den Fig. 18 bis 23, wobei statt E-Komponenten 9 bevorzugt Montageschienen 90 für die Befestigung der 19-Zoll E-Komponenten 9 montiert werden.

In der zusammengebauten Schrankzarge 2, dem zusammengebauten Schrankrahmen 2 bzw. dem zusammengebauten Schrankgehäuse 2 bevorzugt inkl. der Rückwandung 60 können ferner Halterungen für 19 Zoll E-Komponenten 9 verbaut und die 19 Zoll E-Komponenten 9 befestigt werden. Danach werden notwendige elektrische Verbindungen eingerichtet und die Türwandung 50 bzw. die Deckelwandung 50 montiert. Analog zeigt die Fig. 25 den fertigen 19-Zoll E-Schrank 0 mit Türwandung 50 bzw. Deckelwandung 50.

Einen alternativen Aufbau des E-Schranks 0 (dritte Ausführungsform) zeigt die Fig. 26. Ein Schrankgehäuse 2 besteht bevorzugt aus den Seitenwandungen 10, 20, einer Deckenwandung 30, einer Bodenwandung 40, einer Rückwandung 60 und einer Türwandung 50 bzw. Deckelwandung 50. Alle oder auch nur ein Teil der Wandungen 10, 20, 30, 40, 50, 60 können, wie oben (erste und zweite Ausführungsform) auch, aus einem Strangpressprofil z.B. aus einem Leichtmetall, wie z.B. Aluminium aufgebaut sein. Das Strangpressprofil vereint mehrere Funktionen und ersetzt mehrere konventionelle Gehäuseteile. Die Bearbeitung der Strangpressprofile erfolgt, einmal von den V-förmigen Ausschnitten 700, den abgeschrägten Ausschnitten 702 etc., ähnlich wie oben beschrieben.

Im Folgenden ist kursorisch eine Reihenfolge einer Montage (wiederum Vormontage und Endmontage) des E-Schranks 0 mit Komponenten der Steuerungstechnik erläutert. Im Rahmen der Vormontage erfolgt ein Positionieren und Befestigen (s.o.) der vormontierten und vorverdrahteten E-Tafeln 90 (E-Komponente 9) mit Komponenten der Fahrzeugleittechnik. Jeweils in Längsrichtung B, H der Strangpressprofile bzw. anderweitiger Vorrichtungen (vgl. o.) können die E-Tafeln 90 stufenlos verschoben und positioniert werden. Ferner erfolgt ein Positionieren und Befestigen von Kabeldurchführungen 92 (siehe oben) und anderer Komponenten.

Bei der Endmontage des E-Schranks 0 mit Komponenten der Steuerungstechnik werden alle Wandungen 10, 20, 30, 40, 50, 60 mit der Hilfe z.B. geschraubter Verbindungselemente (s.o., vgl. Fig. 20 unten rechts) verbunden. Die vormontierte Rückwandung 60 wird in entsprechende Tragteile (vgl. a.o.) eingeschoben und positioniert. Bei Bedarf wird abgedichtet. Ferner kann ein Vorsehen oder Einbringen zusätzlicher elektrischer Verbindungen erfolgen. Des Weiteren erfolgt bevorzugt ein Befestigen der Türwandung 50 bzw. der Deckelwandung 50.

Die Erfindung beschreibt eine Konstruktion und eine Montage von E-Schänken 0 für einen Einbau von E-Komponenten 9 (ggf. auch andere Komponenten). Die erfindungsgemäße Vereinfachung der E-Schränke 0 erfolgt durch eine Entwicklung und eine Anwendung wenigstens eines multifunktionalen Strangpressprofils bevorzugt aus einem Leichtmetall. Die erfindungsgemäße Schrankzarge 2, der erfindungsgemäße Schrankrahmen 2 oder das erfindungsgemäße Schrankgehäuse 2 besteht teilweise oder vollständig aus einem multifunktionalen Strangpressprofil. Das multifunktionale Strangpressprofil vereint mehrere Funktionen, z.B.: eine Verkleidung, wenigstens ein Tragsystem für eine Integration der E-Komponenten 9, eine Versteifung, Kühlflächen etc., und ersetzt mehrere Gehäuseteile aus dem Stand der Technik. Die Rückwand 60 und/oder die Türwandung 50 bzw. die Deckelwandung 50 können ebenso aus ggf. jeweils einem Strangpressprofil ausgebildet sein und vereinen ebenfalls mehrere Funktionen.

Nach einer mechanischen Bearbeitung der Strangpressprofile werden mehrere mechanische, elektrische und/oder elektronische etc. E-Komponenten 9 an den Strangpressprofilen positioniert, befestigt und nach Bedarf verdrahtet. Eine Befestigung der E-Komponenten 9 erfolgt mittels der Längsnuten 110, 210, 310, 410, 610 in den Strangpressprofilen z.B. über Nutenschrauben oder Nutensteine. Dies ermöglicht ein nachträgliches Verschieben der E-Komponenten 9. Die E-Komponenten 9 können ohne einen Anbau zusätzlicher Halterungen eingebaut werden. Der Zusammenbau des E-Schranks 0 erfolgt durch Biegung und Verbindung von Schrankwandungen 10, 20, 30, 40 zur Schrankzarge 2, zum Schrankrahmen 2 oder zum Schrankgehäuse 2. Durch die Verwendung von Strangpressprofilen mit strukturierter, z.B. geriffelter oder gerippter, Oberfläche, kann deutlich mehr Wärme aus einem E-Schrank 0 abgeführt werden.

## Patentansprüche

1. E-Schrank (0) zum Einbau von E-Komponenten (9) eines Schienenfahrzeugs, wobei der E-Schrank (0) wenigstens zwei Schrankwandungen (10, 20, 30, 40, 50, 60) aufweist, bei dem wenigstens ein Teil der Schrankwandungen (10, 20, 30, 40, 50, 60) als Tragteile (10, 20, 30, 40, 50, 60) ausgebildet sind, bei dem wenigstens ein Tragteil (10, 20, 30, 40, 50, 60) durch wenigstens ein oder genau ein Strangpressprofil im Wesentlichen konstituiert ist,
**dadurch gekennzeichnet,**
**dass** eine Schrankwandung (50) als eine Türwandung (50) und/oder eine Schrankwandung (60) als eine Rückwandung (60) des E-Schranks (0) ausgebildet ist, und
**dass** die Türwandung (50) und/oder die Schrankwandung (60) jeweils aus einem einzigen ursprünglichen Strangpressprofil oder aus unterschiedlichen ursprünglichen Strangpressprofilen hergestellt sind.

2. E-Schrank (0) gemäß vorhergehendem Anspruch, **dadurch gekennzeichnet, dass** eine, zwei, drei, vier oder mehr Schrankwandungen (10, 20, 30, 40) als eine Schrankzarge (2), ein Schrankrahmen (2) oder ein Schrankgehäuse (2) ausgebildet sind, wobei die Schrankzarge (2), der Schrankrahmen (2) oder das Schrankgehäuse (2) durch wenigstens ein oder genau ein Strangpressprofil im Wesentlichen konstituiert ist.

3. E-Schrank (0) gemäß einem der vorhergehenden Ansprüche, **dadurch gekennzeichnet, dass**:
• die/eine Schrankzarge (2) wenigstens ein Tragteil (10, 20, 30, 40) aufweist, welche (2) durch genau ein, genau zwei oder wenigstens ein Strangpressprofil konstituiert ist,
• der/ein Schrankrahmen (2) maximal oder genau drei Tragteile (10, 20, 30, 40) aufweist, welcher (2) durch genau ein, genau zwei oder wenigstens ein Strangpressprofil konstituiert ist,
• das/ein Schrankgehäuse (2) maximal, genau oder wenigstens vier Tragteile (10, 20, 30, 40) aufweist, welches (2) durch genau ein, genau zwei oder wenigstens ein Strangpressprofil konstituiert ist,
• die/eine Schrankwandung (50) genau ein Tragteil (50) umfasst, welche (50) durch genau ein, genau zwei oder wenigstens ein Strangpressprofil konstituiert ist, und/oder,
• die/eine Rückwandung (60) genau ein Tragteil (60) umfasst, welche (60) durch genau ein, genau zwei oder wenigstens ein Strangpressprofil konstituiert ist.

4. E-Schrank (0) gemäß einem der vorhergehenden Ansprüche, **dadurch gekennzeichnet, dass**:
• die Schrankzarge (2), der Schrankrahmen (2) oder das Schrankgehäuse (2), wenigstens zeitlich vor einer Montage des E-Schranks (0), stofflich einstückig oder integral ausgebildet ist bzw. sind,
• das Tragteil (10, 20, 30, 40, 50, 60) stofflich einstückig oder integral ausgebildet ist,
• Tragteile (10, 20; 10, 20, 30; 10, 20, 30, 40; 20, 30, 40; 30, 40), wenigstens zeitlich vor einer Montage des E-Schranks (0), miteinander stofflich einstückig verbunden oder integral ausgebildet sind,
• die Schrankwandung (10, 20, 30, 40, 50, 60) stofflich einstückig oder integral ausgebildet ist,
• Schrankwandungen (10, 20; 10, 20, 30; 10, 20, 30, 40; 20, 30, 40; 30, 40), wenigstens zeitlich vor einer Montage des E-Schranks (0), miteinander stofflich einstückig verbunden oder integral ausgebildet sind.

5. E-Schrank (0) gemäß einem der vorhergehenden Ansprüche, **dadurch gekennzeichnet, dass**:
• sämtliche Schrankwandungen (10, 20, 30, 40, 50, 60) oder Tragteile (10, 20, 30, 40, 50, 60) des E-Schranks (0), aus genau zwei, genau drei, genau vier, genau fünf oder genau sechs unterschiedlichen ursprünglichen Strangpressprofilen hergestellt sind,
• sämtliche Schrankwandungen (10, 20, 30, 40) oder Tragteile (10, 20, 30, 40, 50, 60) der Schrankzarge (2), des Schrankrahmens (2) oder des Schrankgehäuses (2) aus genau einem oder genau zwei unterschiedlichen, ursprünglichen Strangpressprofilen hergestellt sind.

6. E-Schrank (0) gemäß einem der vorhergehenden Ansprüche, **dadurch gekennzeichnet, dass**:
• das Strangpressprofil aus einem Leichtmetall, z.B. Aluminium, hergestellt ist,
• das Strangpressprofil als ein Vollprofil ausgebildet ist,
• die Schrankwandung (10, 20, 30, 40, 50, 60) innen und/oder außen strukturiert ist,
• die Schrankwandung (10, 20, 30, 40, 60) innen wenigstens eine Längsnut (110, 210, 310, 410, 610) zur Befestigung der E-Komponente (9) aufweist,
• der E-Schrank (0) wenigstens eine E-Komponente (9) aufweist, und/oder
• der E-Schrank (0) durch ein Montageverfahren gemäß einem der nachfolgenden Ansprüche hergestellt ist.

7. Verfahren zur Montage eines E-Schranks (0) nach Anspruch 1, z.B. eines Fahrzeug-E-Schranks (0), insbesondere eines Schienenfahrzeug-E-Schranks (0), für einen Einbau von E-Komponenten (9) des Fahrzeugs, insbesondere des Schienenfahrzeugs, wobei der E-Schrank (0) wenigstens zwei Schrankwandungen (10, 20, 30, 40, 50, 60) aufweist, **dadurch gekennzeichnet, dass** zunächst, in einem Rahmen einer Vormontage, wenigstens eine E-Komponente (9) an einem Strangpressprofil für eine Schrankzarge (2), einen Schrankrahmen (2) oder einem Schrankgehäuse (2) und/oder einer Rückwandung (60) des E-Schranks (0) montiert wird, wobei erst in einem zeitlichen Anschluss daran, in einem Rahmen einer Endmontage, die wenigstens zwei Schrankwandungen (10, 20, 30, 40, 50, 60) in ihrer eigentlichen Position im E-Schrank (0) aneinander montiert werden.

8. Montageverfahren gemäß vorhergehendem Anspruch, **dadurch gekennzeichnet, dass** vorbereitend für das Montageverfahren:
• ein Ausschnitt (710) und/oder eine Bohrung (710) in ein Strangpressprofil für die Schrankzarge (2), den Schrankrahmen (2) oder das Schrankgehäuse (2) und/oder die Schrankwandung (50, 60) eingebracht wird,
• ein Ausschnitt (700) und/oder ein abgeschrägter Ausschnitt (702) entsprechend einer Höhe (H) und einer Breite (B) des E-Schranks (0) in das Strangpressprofil für die Schrankzarge (2), den Schrankrahmen (2) bzw. das Schrankgehäuse (2) eingebracht wird,
• die Rückwandung (60) in einem Bereich bei einer Längsnut (610) und/oder in einem Bereich einer Kühleinrichtung bearbeitet wird, und/oder
• die Türwandung (50) in einem Bereich bei einer Profilaufnahme (530), einem Profilschenkel (550) und/oder einer Biegung einer Lasche bearbeitet wird.

9. Montageverfahren gemäß vorhergehendem Anspruch, **dadurch gekennzeichnet, dass** im Rahmen der Vormontage:
• die E-Komponente (9) in/an einer Längsnut (110, 210, 310, 410, 610) des Strangpressprofils für die Schrankzarge (2), den Schrankrahmen (2) oder das Schrankgehäuse (2) und/oder die Rückwandung (60) montiert wird,
• die E-Komponente (9) entlang der Längsnut (110, 210, 310, 410, 610) im Wesentlichen kontinuierlich verschieblich vorgesehen ist, und/oder
• eine Kabeldurchführung (92) und/oder eine andere Komponente am Strangpressprofil für die Schrankzarge (2), den Schrankrahmen (2) oder das Schrankgehäuse (2) und/oder die Rückwandung (60) montiert wird.

10. Montageverfahren gemäß vorhergehendem Anspruch, **dadurch gekennzeichnet, dass** im Rahmen der Endmontage:
• das Strangpressprofil für die Schrankzarge (2), den Schrankrahmen (2) oder das Schrankgehäuse (2) zunächst zu einem Winkel gebogen wird,
• in einem zeitlichen Anschluss daran, die Rückwandung (60) am/im Winkel des Strangpressprofils für die Schrankzarge (2), den Schrankrahmen (2) oder das Schrankgehäuse (2) montiert wird,
• in einem zeitlichen Anschluss daran, das Strangpressprofil für die Schrankzarge (2), den Schrankrahmen (2) oder das Schrankgehäuse (2) zu einem U-förmigen Strangpressprofil an der Rückwandung (60) gebogen wird,
• in einem zeitlichen Anschluss daran, das Strangpressprofil für die Schrankzarge (2), den Schrankrahmen (2) oder das Schrankgehäuse (2) zu einem in einer Umfangsrichtung an der Rückwandung (60) vollständig geschlossenen Strangpressprofil gebogen wird, und/oder
• in einem zeitlichen Anschluss, die Türwandung (50) an der Schrankzarge (2), dem Schrankrahmen (2) oder dem Schrankgehäuse (2) montiert wird.

11. Montageverfahren gemäß einem der vorhergehenden Ansprüche, **dadurch gekennzeichnet, dass** der E-Schrank (0) gemäß einem der vorhergehenden Ansprüche 2 bis 6 ausgebildet ist.

12. Fahrzeug, insbesondere Schienenfahrzeug, **dadurch gekennzeichnet, dass** das Fahrzeug, insbesondere das Schienenfahrzeug, einen E-Schrank (0) gemäß einem der vorhergehenden Ansprüche 2 bis 6 aufweist, und/oder der E-Schrank (0) durch ein Montageverfahren gemäß einem der vorhergehenden Ansprüche 2 bis 6 hergestellt wird.

## Claims

1. E-cabinet (0) for the installation of e-components (9) of a rail vehicle, wherein the e-cabinet (0) has at least two cabinet walls (10, 20, 30, 40, 50, 60), of which at least some of the cabinet walls (10, 20, 30, 40, 50, 60) are in the form of supporting parts (10, 20, 30, 40, 50, 60), of which at least one supporting part (10, 20, 30, 40, 50, 60) is substantially made up of at least one or precisely one extruded profile,
**characterized in that**
one cabinet wall (50) is in the form of a door wall (50), and/or one cabinet wall (60) is in the form of a rear wall (60) of the e-cabinet (0), and
**in that** the door wall (50) and/or the cabinet wall (60) are each produced from a single original extruded profile or from different original extruded profiles.

2. E-cabinet (0) according to the preceding claim, **characterized in that** one, two, three, four or more cabinet walls (10, 20, 30, 40) are in the form of a cabinet body (2), a cabinet frame (2) or a cabinet housing (2), wherein the cabinet body (2), the cabinet frame (2) or the cabinet housing (2) is substantially made up of at least one or precisely one extruded profile.

3. E-cabinet (0) according to either of the preceding claims, **characterized in that**:
• the/a cabinet body (2) has at least one supporting part (10, 20, 30, 40), which cabinet body (2) is made up of precisely one extruded profile, precisely two extruded profiles or at least one extruded profile,
• the/a cabinet frame (2) has a maximum of three or precisely three supporting parts (10, 20, 30, 40), which cabinet frame (2) is made up of precisely one extruded profile, precisely two extruded profiles or at least one extruded profile,
• the/a cabinet housing (2) has a maximum of four, precisely four or at least four supporting parts (10, 20, 30, 40), which cabinet housing (2) is made up of precisely one extruded profile, precisely two extruded profiles or at least one extruded profile,
• the/a cabinet wall (50) comprises precisely one supporting part (50), which (50) is made up of precisely one extruded profile, precisely two extruded profiles or at least one extruded profile, and/or
• the/a rear wall (60) comprises precisely one supporting part (60), which (60) is made up of precisely one extruded profile, precisely two extruded profiles or at least one extruded profile.

4. E-cabinet (0) according to one of the preceding claims, **characterized in that**:
• at least at a point in time prior to assembly of the e-cabinet (0), the cabinet body (2), the cabinet frame (2) or the cabinet housing (2) is or are formed in one piece of material or integrally,
• the supporting part (10, 20, 30, 40, 50, 60) is formed in one piece of material or integrally,
• at least at a point in time prior to assembly of the e-cabinet (0), supporting parts (10, 20; 10, 20, 30; 10, 20, 30, 40; 20, 30, 40; 30, 40) are connected in one piece of material to one another or formed integrally,
• the cabinet wall (10, 20, 30, 40, 50, 60) is formed in one piece of material or integrally,
• at least at a point in time prior to assembly of the e-cabinet (0), cabinet walls (10, 20; 10, 20, 30; 10, 20, 30, 40; 20, 30, 40; 30, 40) are connected in one piece of material to one another or formed integrally.

5. E-cabinet (0) according to one of the preceding claims, **characterized in that**:
• all the cabinet walls (10, 20, 30, 40, 50, 60) or supporting parts (10, 20, 30, 40, 50, 60) of the e-cabinet (0) are produced from precisely two, precisely three, precisely four, precisely five or precisely six different original extruded profiles,
• all the cabinet walls (10, 20, 30, 40) or supporting parts (10, 20, 30, 40, 50, 60) of the cabinet body (2), of the cabinet frame (2) or of the cabinet housing (2) are produced from precisely one original extruded profile or precisely two different, original extruded profiles.

6. E-cabinet (0) according to one of the preceding claims, **characterized in that**:
• the extruded profile is produced from a light metal, e.g. aluminium,
• the extruded profile is in the form of a solid profile,
• the cabinet wall (10, 20, 30, 40, 50, 60) is structured internally and/or externally,
• the cabinet wall (10, 20, 30, 40, 60) has, on its inside, at least one longitudinal groove (110, 210, 310, 410, 610) for the fastening of the e-component (9),
• the e-cabinet (0) has at least one e-component (9), and/or
• the e-cabinet (0) is produced by an assembly method according to one of the following claims.

7. Method for assembling an e-cabinet (0) according to Claim 1, e.g. an e-cabinet (0) of a vehicle, in particular an e-cabinet (0) of a rail vehicle, for installation of e-components (9) of the vehicle, in particular the rail vehicle, wherein the e-cabinet (0) has at least two cabinet walls (10, 20, 30, 40, 50, 60), **characterized in that** in the first instance, in the course of preassembly, at least one e-component (9) is installed on an extruded profile for a cabinet body (2), a cabinet frame (2) or a cabinet housing (2) and/or a rear wall (60) of the e-cabinet (0), wherein it is only at a point in time thereafter, in the course of final assembly, that the at least two cabinet walls (10, 20, 30, 40, 50, 60) are installed on one another in their actual position in the e-cabinet (0).

8. Assembly method according to the preceding claim, **characterized in that**, in preparation for the assembly method:
• a cutout (710) and/or a bore (710) is made in an extruded profile for the cabinet body (2), the cabinet frame (2) or the cabinet housing (2) and/or the cabinet wall (50, 60),
• a cutout (700) and/or a beveled cutout (702) is made, in a manner corresponding to a height (H) and a width (B) of the e-cabinet (0), in the extruded profile for the cabinet body (2), the cabinet frame (2) or the cabinet housing (2),
• the rear wall (60) is machined in a region around a longitudinal groove (610) and/or in a region of a cooling device, and/or
• the door wall (50) is machined in a region around a profile mount (530), a profile limb (550) and/or a bent portion of a lug.

9. Assembly method according to the preceding claim, **characterized in that**, in the course of the preassembly:
• the e-component (9) is installed in/on a longitudinal groove (110, 210, 310, 410, 610) of the extruded profile for the cabinet body (2), the cabinet frame (2) or the cabinet housing (2) and/or the rear wall (60),
• the e-component (9) is provided such that it can be displaced essentially continuously along the longitudinal groove (110, 210, 310, 410, 610), and/or
• a cable bushing (92) and/or some other component is installed on the extruded profile for the cabinet body (2), the cabinet frame (2) or the cabinet housing (2) and/or the rear wall (60).

10. Assembly method according to the preceding claim, **characterized in that**, in the course of the final assembly:
• the extruded profile for the cabinet body (2), the cabinet frame (2) or the cabinet housing (2) in the first instance is bent at an angle,
• at a point in time thereafter, the rear wall (60) is installed at the angle of the extruded profile for the cabinet body (2), the cabinet frame (2) or the cabinet housing (2),
• at a point in time thereafter, the extruded profile for the cabinet body (2), the cabinet frame (2) or the cabinet housing (2) is bent to form a U-shaped extruded profile on the rear wall (60),
• at a point in time thereafter, the extruded profile for the cabinet body (2), the cabinet frame (2) or the cabinet housing (2) is bent to form a circumferentially completely closed extruded profile on the rear wall (60), and/or
• at a point in time thereafter, the door wall (50) is installed on the cabinet body (2), the cabinet frame (2) or the cabinet housing (2).

11. Assembly method according to one of the preceding claims, **characterized in that** the e-cabinet (0) is formed according to one of the preceding Claims 2 to 6.

12. Vehicle, in particular a rail vehicle, **characterized in that** the vehicle, in particular the rail vehicle, has an e-cabinet (0) according to one of the preceding Claims 2 to 6, and/or the e-cabinet (0) is produced by an assembly method according to one of the preceding Claims 2 to 6.

## Revendications

1. Armoire électronique (0) pour le montage de composants électroniques (9) d'un véhicule ferroviaire, dans laquelle l'armoire électronique (0) présente au moins deux parois d'armoire (10, 20, 30, 40, 50, 60), dans laquelle au moins une partie des parois d'armoire (10, 20, 30, 40, 50, 60) sont conçues comme des éléments porteurs (10, 20, 30, 40, 50, 60), dans laquelle au moins un élément porteur (10, 20, 30, 40, 50, 60) est essentiellement constitué par au moins un ou exactement un profil extrudé, **caractérisée en ce qu'**une paroi d'armoire (50) est conçue comme une paroi formant porte (50) et / ou une paroi d'armoire (60) comme une paroi arrière (60) de l'armoire électronique (0), et **en ce que** la paroi formant porte (50) et / ou la paroi d'armoire (60) sont fabriquées à chaque fois à partir d'un seul profil extrudé initial ou à partir de différents profils extrudés initiaux.

2. Armoire électronique (0) selon la revendication précédente, **caractérisée en ce qu'**une, deux, trois, quatre parois d'armoire (10, 20, 30, 40) ou plus sont conçues comme un châssis d'armoire (2), un cadre d'armoire (2) ou un corps d'armoire (2), dans laquelle le châssis d'armoire (2), le cadre d'armoire (2) ou le corps d'armoire (2) est essentiellement constitué par au moins un ou exactement un profil extrudé.

3. Armoire électronique (0) selon l'une des revendications précédentes, **caractérisée en ce que** :
. le / un châssis d'armoire (2) présente au moins un élément porteur (10, 20, 30, 40), lequel (2) est constitué par exactement un, exactement deux ou au moins un profil extrudé,
. le / un cadre d'armoire (2) présente au maximum ou exactement trois éléments porteurs (10, 20, 30, 40), lequel (2) est constitué par exactement un, exactement deux ou au moins un profil extrudé,
. le / un corps d'armoire (2) présente au maximum, exactement ou au moins quatre éléments porteurs (10, 20, 30, 40), lequel (2) est constitué par exactement un, exactement deux ou au moins un profil extrudé,
. la / une paroi d'armoire (50) comprend exactement un élément porteur (50), lequel (50) est constitué par exactement un, exactement deux ou au moins un profil extrudé, et / ou,
. la / une paroi arrière (60) comprend exactement un élément porteur (60), lequel (60) est constitué par exactement un, exactement deux ou au moins un profil extrudé.

4. Armoire électronique (0) selon l'une des revendications précédentes, **caractérisée en ce que** :
. le châssis d'armoire (2), le cadre d'armoire (2) ou le corps d'armoire (2), au moins temporellement avant un montage de l'armoire électronique (0), est ou sont conçu(s)matériellement d'une seule pièce ou intégralement,
• l'élément porteur (10, 20, 30, 40, 50, 60) est conçu matériellement d'une seule pièce ou intégralement,
• des éléments porteurs (10, 20 ; 10, 20, 30 ; 10, 20, 30, 40 ; 20, 30, 40 ; 30, 40), au moins temporellement avant un montage de l'armoire électronique (0), sont reliés ensemble matériellement d'une seule pièce ou sont conçus intégralement,
• la paroi d'armoire (10, 20, 30, 40, 50, 60) est conçue matériellement d'une seule pièce ou intégralement,
• des parois d'armoire (10, 20 ; 10, 20, 30 ; 10, 20, 30, 40 ; 20, 30, 40 ; 30, 40), au moins temporellement avant un montage de l'armoire électronique (0), sont reliées ensemble matériellement d'une seule pièce ou sont conçues intégralement.

5. Armoire électronique (0) selon l'une des revendications précédentes, **caractérisée en ce que** :
• toutes les parois d'armoire (10, 20, 30, 40, 50, 60) ou tous les éléments porteurs (10, 20, 30, 40, 50, 60) de l'armoire électronique (0), sont fabriqué(e)s à partir d'exactement deux, exactement trois, exactement quatre, exactement cinq ou exactement six différents profils extrudés initiaux,
• toutes les parois d'armoire (10, 20, 30, 40) ou tous les éléments porteurs (10, 20, 30, 40, 50, 60) du châssis d'armoire (2), du cadre d'armoire (2) ou du corps d'armoire (2) sont fabriqué(e)s à partir d'exactement un ou exactement deux différents profils extrudés initiaux.

6. Armoire électronique (0) selon l'une des revendications précédentes, **caractérisée en ce que** :
• le profil extrudé est fabriqué à partir d'un métal léger, par exemple, de l'aluminium,
• le profil extrudé est conçu comme un profil plein,
• la paroi d'armoire (10, 20, 30, 40, 50, 60) est structurée à l'intérieur et / ou à l'extérieur,
• la paroi d'armoire (10, 20, 30, 40, 60) présente à l'intérieur au moins une rainure longitudinale (110, 210, 310, 410, 610) pour la fixation des composants électroniques (9),
• l'armoire électronique (0) présente au moins un composant électronique (9), et / ou
• l'armoire électronique (0) est fabriquée par un procédé de montage selon l'une des revendications suivantes.

7. Procédé de montage d'une armoire électronique (0) selon la revendication 1, par exemple, d'une armoire électronique de véhicule (0), plus particulièrement d'une armoire électronique de véhicule ferroviaire (0), pour un montage de composants électroniques (9) du véhicule, plus particulièrement du véhicule ferroviaire, dans lequel l'armoire électronique (0) présente au moins deux parois d'armoire (10, 20, 30, 40, 50, 60), **caractérisé en ce que** d'abord, dans un cadre de prémontage, est monté au moins un composant électronique (9) sur un profil extrudé pour un châssis d'armoire (2), un cadre d'armoire (2) ou un corps d'armoire (2) et / ou à une paroi arrière (60) de l'armoire électronique (0), dans lequel seulement dans un second temps, dans le cadre d'un montage final, les au moins deux parois d'armoire (10, 20, 30, 40, 50, 60) sont montées l'une contre l'autre dans leur position effective dans l'armoire électronique (0) .

8. Procédé de montage selon la revendication précédente, **caractérisé en ce qu'**en préparation du procédé de montage :
• une découpure (710) et / ou un alésage (710) est mis(e) en place dans un profil extrudé pour le châssis d'armoire (2), le cadre d'armoire (2) ou le corps d'armoire (2) et / ou la paroi d'armoire (50, 60),
• une découpure (700) et / ou une découpure biseautée (702) correspondant à une hauteur (H) et à une largeur (B) de l'armoire électronique (0) est mise en place dans le profil extrudé pour le châssis d'armoire (2), le cadre d'armoire (2) ou le corps d'armoire (2),
• la paroi arrière (60) est usinée dans une zone près d'une rainure longitudinale (610) et / ou dans une zone d'un dispositif de refroidissement, et / ou
• la paroi formant porte (50) est usinée dans une zone près d'un logement de profil (530), d'une branche de profil (550) et / ou d'un cintrage d'une bride.

9. Procédé de montage selon la revendication précédente, **caractérisé en ce que** dans le cadre du prémontage :
• le composant électronique (9) est monté dans / sur une rainure longitudinale (110, 210, 310, 410, 610) du profil extrudé pour le châssis d'armoire (2), le cadre d'armoire (2) ou le corps d'armoire (2) et / ou la paroi arrière (60),
• le composant électronique (9) est prévu le long de la rainure longitudinale (110, 210, 310, 410, 610) d'une manière essentiellement déplaçable en continu, et / ou
• un passage de câble (92) et / ou un autre composant est monté sur le profil extrudé pour le châssis d'armoire (2), le cadre d'armoire (2) ou le corps d'armoire (2) et / ou la paroi arrière (60) .

10. Procédé de montage selon la revendication précédente, **caractérisé en ce que** dans le cadre du montage final :
• le profil extrudé pour le châssis d'armoire (2), le cadre d'armoire (2) ou le corps d'armoire (2) est d'abord plié en angle,
• par la suite, la paroi arrière (60) est montée sur / en angle du profil extrudé pour le châssis d'armoire (2), le cadre d'armoire (2) ou le corps d'armoire (2),
• par la suite, le profil extrudé pour le châssis d'armoire (2), le cadre d'armoire (2) ou le corps d'armoire (2) est cintré en un profil extrudé en forme de U sur la paroi arrière (60),
• par la suite, le profil extrudé pour le châssis d'armoire (2), le cadre d'armoire (2) ou le corps d'armoire (2) est cintré en un profil extrudé fermé intégralement dans un sens périphérique sur la paroi arrière (60), et / ou
• par la suite, la paroi formant porte (50) est montée sur le châssis d'armoire (2), le cadre d'armoire (2) ou le corps d'armoire (2).

11. Procédé de montage selon l'une des revendications précédentes, **caractérisé en ce que** l'armoire électronique (0) est conçue selon l'une des revendications précédentes 2 à 6.

12. Véhicule, plus particulièrement véhicule ferroviaire, **caractérisé en ce que** le véhicule, plus particulièrement le véhicule ferroviaire, présente une armoire électronique (0) selon l'une des revendications précédentes 2 à 6, et / ou l'armoire électronique (0) est fabriquée par un procédé de montage selon l'une des revendications précédentes 2 à 6.
